Europäisches Patentamt

European Patent Office

Office européen des brevets

(19)

(11) **EP 1 496 613 A1**

(12) **DEMANDE DE BREVET EUROPEEN**

(43) Date de publication:
**12.01.2005 Bulletin 2005/02**

(51) Int Cl.[7]: **H03F 3/50**, H03F 3/345

(21) Numéro de dépôt: **03405513.7**

(22) Date de dépôt: **09.07.2003**

(84) Etats contractants désignés:
**AT BE BG CH CY CZ DE DK EE ES FI FR GB GR HU IE IT LI LU MC NL PT RO SE SI SK TR**
Etats d'extension désignés:
**AL LT LV MK**

(71) Demandeur: **C.S.E.M. CENTRE SUISSE D'ELECTRONIQUE ET DE MICROTECHNIQUE SA**
**2007 Neuchâtel (CH)**

(72) Inventeur: **Heim, Pascal**
**2022 Bevaix (CH)**

(74) Mandataire: **Gresset, Jean**
**GLN**
**Gresset & Laesser Neuchâtel**
**Puits-Godet 8A**
**2000 Neuchâtel (CH)**

(54) **Circuit suiveur à la source**

(57) L'invention concerne un circuit suiveur à la source doté d'une entrée $V_{in}$, d'une sortie $V_{out}$, d'une borne d'alimentation positive $V_{DD}$ et d'une borne d'alimentation négative $V_{SS}$. Il comporte :

- une source de courant (17) munie d'une entrée (E) et d'une sortie (S) et recevant, en entrée, un courant $I_{mir}$,
- un transistor suiveur (18) alimenté par ladite source (17), connecté entre l'entrée $V_{in}$ et la sortie $V_{out}$ et

divisé en au moins deux éléments (23, 24), chacun traversé par un courant $I_{suiv}$, dont l'un (23) possède la fonction de simple suiveur à la source et dont l'autre (24) sert à mesurer le courant dans une charge capacitive (19) reliant sa sortie $V_{out}$ et sa borne $V_{SS}$, et agit sur ladite source (17), et
- un bloc soustracteur de courant (20) recevant un courant de polarisation $I_{bias}$ et destiné à fournir à l'entrée (E) de ladite source (17) un courant $I_{mir} = I_{bias} - I_{suiv}$.

FIG. 3

## Description

La présente invention se rapporte au domaine des circuits électroniques. Elle concerne, plus particulièrement, un circuit suiveur à la source.

Un suiveur à la source est un circuit souvent utilisé pour maintenir des tensions de polarisation sur lesquelles des charges sont commutées. Il présente, classiquement, une grande impédance d'entrée et une faible impédance de sortie, ce qui lui permet de fournir de l'énergie en sortie quasiment sans perturber une source de commande appliquée à son entrée.

Les suiveurs à la source doivent :

- être performants, c'est-à-dire être capables de fournir une grande énergie à leur sortie,
- être fidèles, c'est-à-dire être capables de restituer exactement les rampes des signaux entrants, et
- avoir un bon rendement énergétique.

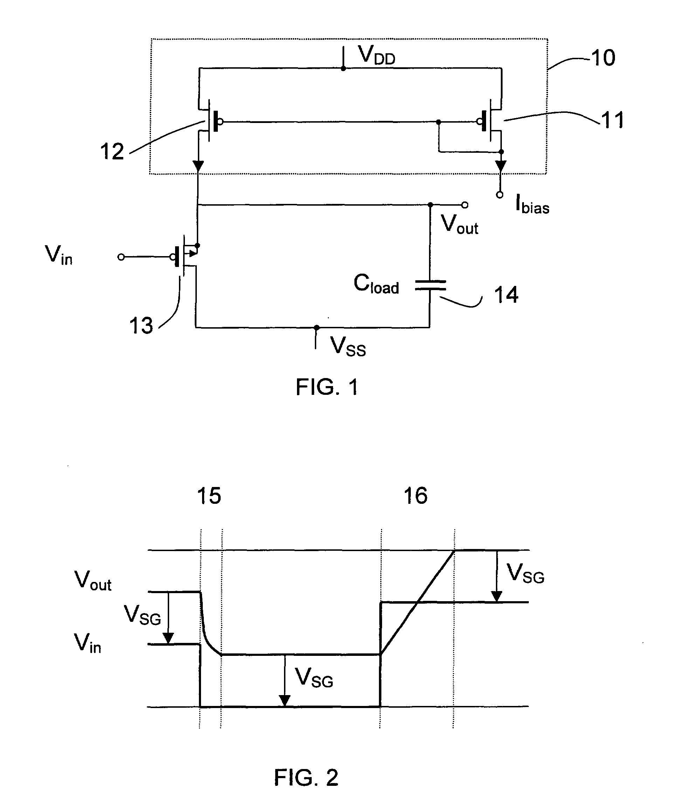

Dans le cas d'un suiveur à la source de type P, bien connu de l'homme de métier et illustré sur la figure 1, une source de courant 10 est formée par un miroir de courant de gain 1. Celui-ci est constitué de deux transistors 11 et 12 et est traversé par un courant de polarisation $I_{bias}$ qui est acheminé à la source d'un transistor suiveur 13 dont la grille reçoit un signal d'entrée $V_{in}$. La source du transistor 13 constituant également la sortie $V_{out}$ du circuit, est reliée à une capacité $C_{load}$ 14, qui représente la charge capacitive dudit circuit. Pour maintenir constante la tension entre sa grille et sa source, la source du transistor 13 est connectée au substrat. Le circuit est également doté d'une borne d'alimentation positive $V_{DD}$ et d'une borne d'alimentation négative $V_{SS}$.

De manière évidente, on constate que ce type de suiveur est totalement asymétrique. Son comportement en mode dynamique est illustré par le diagramme temporel de la figure 2 explicitant la différence fondamentale entre les transitoires entraînés par le transistor suiveur 13 et ceux entraînés par la source de courant 10.

Lors d'une transition négative 15, la tension de sortie $V_{out}$ est entraînée par le transistor suiveur 13 et est essentiellement fonction de sa largeur. Le début du transitoire profite d'une augmentation brusque de la tension Source-Grille $V_{SG}$, qui permet de fournir un courant beaucoup plus grand que $I_{bias}$ à la charge 14, alors que la fin du transitoire dépend de la valeur de la transconductance de source du transistor suiveur 13.

En revanche, lors d'une transition positive 16, la tension de sortie $V_{out}$ est entraînée uniquement par le courant de polarisation $I_{bias}$, ce qui donne un comportement de type "slew rate" sous charge capacitive. Le temps de transition est alors donné par la formule :

$$T_{up} = C_{load} \; \Delta V_{out}/I_{bias}$$

La seule façon de réduire le temps de transition $T_{up}$ pour une charge capacitive $C_{load}$ donnée est d'augmenter le courant $I_{bias}$, c'est-à-dire la consommation globale du circuit au repos, ce qui est particulièrement préjudiciable dans le cas des systèmes à faible puissance. Par ailleurs, si l'on veut limiter la tension $V_{SG}$ à une valeur raisonnable, il faut élargir le transistor suiveur en conséquence, ce qui aura pour effet d'augmenter encore l'asymétrie structurelle du suiveur.

On pourrait également diminuer la charge capacitive, mais celle-ci est généralement imposée par le système dans lequel prend place le circuit.

La présente invention a pour but de fournir un suiveur à la source dont les transitions, particulièrement la transition positive, sont rapides et dont la consommation de courant statique est très réduite.

De façon plus précise, l'invention concerne un circuit suiveur à la source doté d'une entrée $V_{in}$, d'une sortie $V_{out}$, d'une borne d'alimentation positive $V_{DD}$ et d'une borne d'alimentation négative $V_{SS}$. Ce circuit comporte :

- une source de courant munie d'une entrée E et d'une sortie S et recevant, en entrée, un courant $I_{mir}$,
- un transistor suiveur alimenté par la source de courant, connecté entre l'entrée $V_{in}$ et la sortie $V_{out}$ et divisé en au moins deux éléments, chacun traversé par un courant $I_{suiv}$, dont l'un possède la fonction de simple suiveur à la source et dont l'autre sert à mesurer le courant dans une charge capacitive reliant la sortie $V_{out}$ et la borne $V_{SS}$, et agit sur la source de courant, et
- un bloc soustracteur de courant recevant un courant de polarisation $I_{bias}$ et destiné à fournir à l'entrée E de la source un courant $I_{mir} = I_{bias}-I_{suiv}$.

Le circuit selon l'invention est tel que, en mode dynamique :

- ■ au cours d'une transition négative, la source de courant est momentanément coupée, et
- ■ au cours d'une transition positive, la charge est suralimentée afin de raccourcir la durée de cette transition.

De manière avantageuse, le circuit suiveur selon l'invention comporte encore les caractéristiques suivantes :

- la source de courant est formée d'un miroir de courant réalisé au moyen d'un premier transistor relié au bloc soustracteur de courant et d'un deuxième transistor relié au transistor suiveur, ce miroir procurant un effet de gain M supérieur à l'unité ;
- les premier et deuxième transistors sont respectivement réalisés au moyen de n éléments en série et de m éléments en parallèle, procurant ainsi un effet de gain M = n x m ;

- les sources des premier et deuxième transistors sont reliées ensemble à la borne d'alimentation positive $V_{DD}$ ;
- les grilles des premier et deuxième transistors sont reliées ensemble et au drain du premier transistor ;
- les sources des deux éléments du transistor suiveur sont reliées à la sortie S de la source de courant et à la sortie $V_{out}$ ;
- les grilles des deux éléments du transistor suiveur sont reliées à l'entrée $V_{in}$ ;
- le drain d'au moins un des deux éléments du transistor suiveur est connecté au bloc soustracteur de courant ; et
- les deux éléments du transistor suiveur sont identiques.

De préférence, le bloc soustracteur de courant comporte :

- un miroir de courant constitué d'un premier et d'un deuxième transistors, dont :

  ■ les sources sont reliées ensemble au drain de l'élément du transistor assurant la fonction de suiveur et à la borne négative $V_{SS}$ d'alimentation du circuit ;
  ■ les grilles sont interconnectées et reliées au drain du deuxième transistor recevant le courant de polarisation $I_{bias}$ ;
  ■ le drain du premier transistor est relié au drain de l'élément du transistor suiveur mesurant le courant dans ladite charge ; et

- un transistor pseudo-cascode dont la source est reliée au drain du premier transistor, dont le drain est connecté à l'entrée E de la source de courant et dont la grille est reliée à l'entrée du courant $I_{bias}$ et aux grilles des premier et deuxième transistors du bloc soustracteur.

Afin de favoriser le passage du courant en direction de la source de courant, la longueur du transistor pseudo-cascode est sensiblement inférieure à celle du premier transistor du bloc soustracteur.

Eventuellement, le circuit suiveur comprend, en outre, une capacité de compensation connectée entre le drain de l'élément du transistor mesurant le courant dans la charge et l'entrée E de la source de courant.

D'autres caractéristiques de l'invention apparaîtront plus clairement à la lecture de la description qui suit, faite en regard du dessin annexé dans lequel :

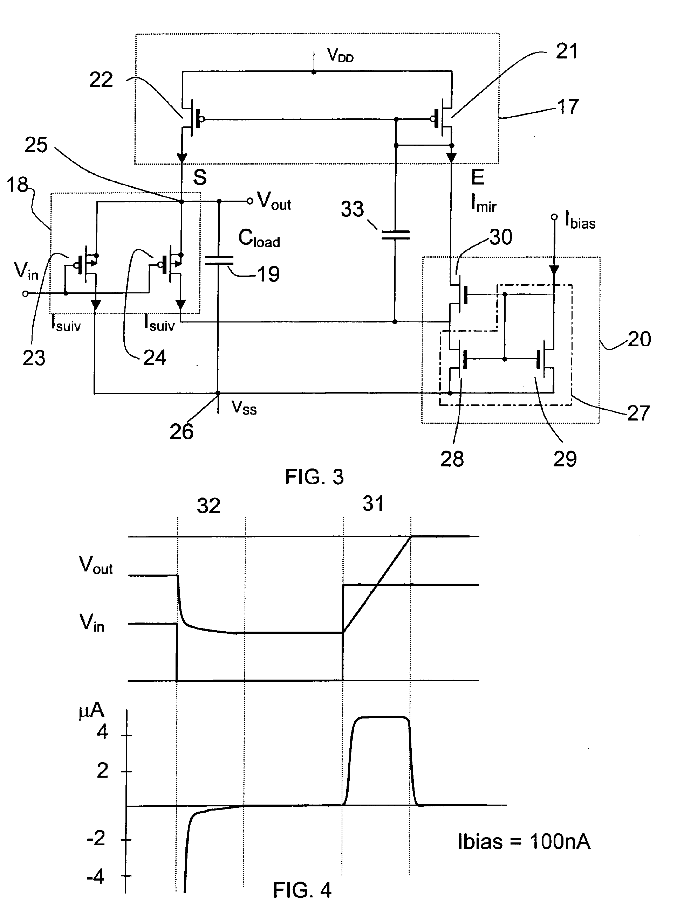

- la figure 3 est un schéma de principe d'un suiveur à la source selon l'invention, et
- la figure 4 représente des simulations du comportement de ce circuit.

A l'instar du suiveur classique représenté à la figure 1, le suiveur selon l'invention comporte une source de courant 17 formée d'un miroir de courant et alimentant un transistor suiveur 18 relié à une charge capacitive 19 $C_{load}$.

A la différence d'un suiveur classique, le suiveur selon l'invention comprend, en outre, un bloc 20, dit miroir soustracteur de courant, recevant un courant de polarisation $I_{bias}$ et relié à l'entrée E de la source de courant 17.

Plus précisément, le miroir 17 est réalisé au moyen de deux transistors à canal P 21 et 22, dont les sources sont reliées à une borne d'alimentation positive $V_{DD}$ et les grilles sont reliées ensemble. Par ailleurs, les deux grilles sont reliées au drain du transistor 21. Ces transistors ne sont pas identiques, de manière à procurer un effet de gain M supérieur à 1. Typiquement, les transistors 21 et 22 sont respectivement réalisés au moyen de n éléments en série et de m éléments en parallèle, n et m désignant des entiers quelconques. Ainsi, un courant $I_{mir}$ arrivant à l'entrée E, formée par le drain du transistor 21, procure à la sortie S du miroir 17, formée par le drain du transistor 22, un courant M = n x m fois plus grand.

Le transistor suiveur 18 est divisé en deux éléments, ou transistors à canal P, 23 et 24 identiques, dont les sources sont reliées en un noeud 25 à la sortie S du miroir 17 et à une borne de sortie $V_{out}$. Leurs grilles sont, chacune, connectées à une borne d'entrée $V_{in}$ et, enfin, leurs drains rejoignent, chacun, le bloc soustracteur de courant 20 d'une manière qui sera précisée plus loin. Comme dans l'art antérieur précité, les éléments 23 et 24 ont leur source connectée au substrat.

Au repos, les éléments 23 et 24 sont chacun traversés par un courant $I_{suiv}$. On a donc la relation $2I_{suiv}$ = M x $I_{mir}$.

L'élément 23 possède la fonction originale du simple suiveur à la source, alors que l'élément 24 est utilisé pour mesurer le courant dans la charge $C_{load}$ 19. Celle-ci est connectée entre la sortie $V_{out}$ et un noeud 26 correspondant à une borne d'alimentation négative $V_{SS}$ du circuit.

Le bloc soustracteur de courant 20 est destiné à fournir à la source un courant $I_{mir} = I_{bias} - I_{suiv}$. Il comporte un miroir de courant 27 de gain 1, constitué de deux transistors à canal N 28 et 29, dont les grilles sont interconnectées et dont les sources sont reliées ensemble au noeud 26 et à la borne négative d'alimentation du circuit $V_{SS}$. Le drain du transistor 29 reçoit le courant de polarisation $I_{bias}$ tandis que le drain du transistor 28 est relié, d'une part, au drain de l'élément 24 et, d'autre part, à la source d'un transistor à canal N 30 nommé pseudo-cascode, qui fait partie intégrante du bloc 20. Le drain du pseudo-cascode 30 est connecté à l'entrée E du miroir 17. Sa grille est reliée, d'une part, à l'entrée du courant $I_{bias}$ et, d'autre part, aux grilles des transistors 28 et 29.

On notera que la longueur du pseudo-cascode 30 doit être beaucoup plus petite (environ dix fois) que celle du transistor 28, de manière à favoriser le passage du courant en direction de la source 17 sans, toutefois, modifier sensiblement le gain unité du miroir de courant 27.

En fonctionnement, au cours d'une transition négative, c'est le transistor suiveur 18 qui entraîne la charge 19. D'une part, l'élément 24 apporte à celle-ci un faible courant dérivé du miroir 27 du bloc soustracteur 20 et qui ne peut donc être plus grand que $I_{bias}$. D'autre part, l'élément 23 fournit, au début de la transition, la plus grande partie du courant. Ensuite, comme $I_{bias}$ rentre dans le miroir 27 et que l'élément 24 absorbe ce courant, le pseudo-cascode 30 ne reçoit plus aucun courant, ce qui entraîne, dans une deuxième phase, la coupure momentanée de la source de courant 17 de l'élément 23.

Au cours d'une transition positive, c'est la source de courant 17 qui entraîne la charge 19. Les éléments 23 et 24 du transistor suiveur 18 se bloquent à cause de l'augmentation rapide de leur tension d'entrée, de sorte que, dans le bloc soustracteur 20, tout le courant de polarisation $I_{bias}$ provenant du miroir 27 est dirigé à travers le pseudo-cascode 30 vers la source 17, dans lequel il est multiplié par le facteur M et suralimente directement la charge de manière à raccourcir la durée de cette transition.

Le comportement dynamique du suiveur selon l'invention est illustré sur la figure 4 représentant, en fonction du temps, les tensions d'entrée $V_{in}$ et de sortie $V_{out}$ et l'intensité traversant la charge capacitive 19. On peut constater que, pour la tension, les transitoires positif 31 et négatif 32 demeurent asymétriques, respectivement de type "slew-rate" et de type exponentiel, mais qu'ils s'étendent sur une durée très voisine. Au niveau de l'intensité, on observe au moment du transitoire positif 31 que, pour un courant de polarisation de 100nA et pour une source 17 dans laquelle n = 6 et m = 8, le courant mesuré dans la charge est bien d'environ 4,8μA (48 x 100nA).

Le circuit tel que décrit ci-dessus est légèrement sous-amorti. Si l'on veut pallier cet inconvénient, il est possible d'ajouter une capacité de compensation 33 connectée entre le drain de l'élément 24 et l'entrée E du miroir 17.

Le suiveur selon l'invention permet ainsi de tenir une forte tension de polarisation, en limitant à la transition positive, l'augmentation de la consommation de courant nécessaire à cet effet. De plus, ce circuit est particulièrement simple à réaliser, à dimensionner et à simuler. On s'aperçoit même que, ce que l'homme de métier appelle les effets de mismatches, c'est à dire des dysfonctionnements dus à l'impossibilité de réaliser deux transistors parfaitement identiques, ces effets, affectant le miroir de courant 17, sont divisés par son gain M pour donner un mismatch global comparable à celui d'un suiveur simple.

Bien entendu, le gain M du miroir de courant 17 peut être facilement adapté à une application particulière en modifiant le rapport de dimension entre les transistors 21 et 22.

## Revendications

1. Circuit suiveur à la source doté d'une entrée $V_{in}$, d'une sortie $V_{out}$, d'une borne d'alimentation positive $V_{DD}$ et d'une borne d'alimentation négative $V_{SS}$, **caractérisé en ce qu'**il comporte :

   - une source de courant (17) munie d'une entrée (E) et d'une sortie (S) et recevant, en entrée, un courant $I_{mir}$,
   - un transistor suiveur (18) alimenté par ladite source (17), connecté entre l'entrée $V_{in}$ et la sortie $V_{out}$ et divisé en au moins deux éléments (23, 24), chacun traversé par un courant $I_{suiv}$, dont l'un (23) possède la fonction de simple suiveur à la source et dont l'autre (24) sert à mesurer le courant dans une charge capacitive (19) reliant sa sortie $V_{out}$ et sa borne $V_{ss}$, et agit sur ladite source (17), et
   - un bloc soustracteur de courant (20) recevant un courant de polarisation $I_{bias}$ et destiné à fournir à l'entrée (E) de ladite source (17) un courant $I_{mir} = I_{bias} - I_{suiv}$,
   - ledit circuit étant tel que, en mode dynamique :

     ■ au cours d'une transition négative, ladite source de courant (17) est momentanément coupée, et
     ■ au cours d'une transition positive, ladite charge (19) est suralimentée afin de raccourcir la durée de cette transition.

2. Circuit suiveur selon la revendication 1, **caractérisé en ce que** ladite source de courant (17) est formée d'un miroir de courant réalisé au moyen d'un premier transistor (21) relié audit bloc soustracteur de courant (20) et d'un deuxième transistor (22) relié audit transistor suiveur (18), ledit miroir procurant un effet de gain M supérieur à un.

3. Circuit suiveur selon la revendication 2, **caractérisé en ce que** lesdits premier (21) et deuxième (22) transistors sont respectivement réalisés au moyen de n éléments en série et de m éléments en parallèle, procurant ainsi un effet de gain M = n x m.

4. Circuit suiveur selon l'une des revendications 2 et 3, **caractérisé en ce que** les sources desdits premier et deuxième transistors (21, 22) sont reliées ensemble à la borne d'alimentation positive $V_{DD}$ et **en ce que** leur grilles sont reliées ensemble et au drain dudit premier transistor (21).

**5.** Circuit suiveur selon l'une des revendications 1 à 4, **caractérisé en ce que** les sources des deux éléments (23, 24) du transistor suiveur (18) sont reliées à la sortie (S) de ladite source de courant (17) et à la sortie $V_{out}$, **en ce que** leur grilles sont reliées à l'entrée $V_{in}$, et **en ce que** leur drains sont connectés audit bloc soustracteur de courant (20).

**6.** Circuit suiveur selon l'une des revendications 1 à 5, **caractérisé en ce que** les deux éléments (23, 24) du transistor suiveur (18) sont identiques.

**7.** Circuit suiveur selon l'une des revendications 1 à 6, **caractérisé en ce que** ledit bloc soustracteur de courant (20) comporte :

- un miroir de courant (27), constitué d'un premier (28) et d'un deuxième (29) transistors, dont :

  ■ les sources sont reliées ensemble au drain de l'élément (23) du transistor (18) assurant la fonction de suiveur et à la borne d'alimentation négative $V_{SS}$ ;
  ■ les grilles sont interconnectées et reliées au drain du deuxième transistor (29) recevant le courant de polarisation $I_{bias}$ ;
  ■ le drain du premier transistor (28) est relié au drain de l'élément (24) du transistor suiveur (18) mesurant le courant dans ladite charge (19) ; et

- un transistor pseudo-cascode (30) dont la source est reliée au drain dudit premier transistor (28), dont le drain est connecté à ladite entrée (E) de ladite source de courant (17) et dont la grille est reliée à l'entrée du courant $I_{bias}$ et aux grilles des premier et deuxième transistors (28, 29) du bloc soustracteur (20).

**8.** Circuit suiveur selon la revendication 7, **caractérisé en ce que** la longueur du transistor pseudo-cascode (30) est sensiblement inférieure à celle du premier transistor (28) du bloc soustracteur (20), de manière à favoriser le passage du courant en direction de la source de courant (17).

**9.** Circuit suiveur selon l'une des revendications 1 à 8, **caractérisé en ce qu'**il comprend, en outre, une capacité de compensation (33) connectée entre le drain de l'élément (24) du transistor (18) mesurant le courant dans ladite charge (19) et l'entrée (E) de la source de courant (17).

FIG. 1

FIG. 2

FIG. 3

Ibias = 100nA

FIG. 4

**Office européen**
**des brevets**

## RAPPORT DE RECHERCHE EUROPEENNE

Numéro de la demande

EP 03 40 5513

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| Y | US 5 365 199 A (BROOKS TODD L) 15 novembre 1994 (1994-11-15) * colonne 5, ligne 65 - colonne 7, ligne 5; figure 4 * --- | 1-9 | H03F3/50 H03F3/345 |
| Y | US 5 121 082 A (MATSUZAWA AKIRA) 9 juin 1992 (1992-06-09) * colonne 3, ligne 33 - colonne 4, ligne 61; figures 3,4 * --- | 1-9 | |
| A | EP 1 061 427 A (ST MICROELECTRONICS SRL) 20 décembre 2000 (2000-12-20) * colonne 2, ligne 19-29; figures 4,5 * * colonne 3, ligne 43-57 * --- | 2,3,8 | |
| A | US 4 739 281 A (DOYLE JOHN G) 19 avril 1988 (1988-04-19) * colonne 4, ligne 62 - colonne 5, ligne 49; figure 3 * ----- | 1-9 | |

| | | | DOMAINES TECHNIQUES RECHERCHES (Int.Cl.7) |
|---|---|---|---|
| | | | H03F |

Le présent rapport a été établi pour toutes les revendications

| Lieu de la recherche | Date d'achèvement de la recherche | Examinateur |
|---|---|---|
| LA HAYE | 9 décembre 2003 | Fedi, G |

**ANNEXE AU RAPPORT DE RECHERCHE EUROPEENNE
RELATIF A LA DEMANDE DE BREVET EUROPEEN NO.**   EP 03 40 5513

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

09-12-2003

| Document brevet cité au rapport de recherche | | Date de publication | Membre(s) de la famille de brevet(s) | | Date de publication |
|---|---|---|---|---|---|
| US 5365199 | A | 15-11-1994 | CN | 1103215 A ,B | 31-05-1995 |
| US 5121082 | A | 09-06-1992 | JP | 3186005 A | 14-08-1991 |
| EP 1061427 | A | 20-12-2000 | EP | 1061427 A1 | 20-12-2000 |
| | | | DE | 69902889 D1 | 17-10-2002 |
| | | | US | 6392393 B1 | 21-05-2002 |
| US 4739281 | A | 19-04-1988 | AUCUN | | |

EPO FORM P0460